# FASCICULE DE BREVET EUROPEEN

(11) **EP 2 150 972 B1**
(45) Date de publication et mention de la délivrance du brevet: **12.09.2018**
(21) Numéro de dépôt: 08805695.7
(22) Date de dépôt: 23.04.2008
(51) Int. Cl.: H01L 21/60

(54) **Procédé d'assemblage d'un module électronique comprenant un organe assemblé sur un support par frittage d'une masse de poudre conductrice**
Verfahren zur Montage eines elektronischen Moduls mit einem auf einem Träger durch Sintern einer leitenden pulverförmigen Masse montierten Bauelement
Method for assembling an electronic module comprising an element assembled onto a carrier by sintering a conducting powder

(30) Priorité: 30.04.2007 FR 0754807
(43) Date de publication de la demande: 10.02.2010
(73) Titulaire: Valeo Etudes Electroniques, 94042 Créteil Cédex (FR)
(72) Inventeur: MORELLE, Jean-Michel, 45190 Beaugency (FR); VIVET, Laurent, 78390 Bois D'Arcy (FR); MEDINA, Mathieu, 33600 Pessac (FR); DIMELLI, Sandra, 78390 Bois D'Arcy (FR)
(74) Mandataire: Cardon, Nicolas
(86) Numéro de dépôt international: PCT/FR2008/050741
(87) Numéro de publication internationale: WO 2008/145930

(56) Documents cités:
- EP-A- 0 242 626
- EP-A- 1 599 078
- US-A- 4 281 236
- US-A- 5 158 226
- US-A1- 2003 102 356

## Description

La présente invention concerne un procédé d'assemblage d'un module électronique comprenant un organe destiné à être assemblé sur un support, et plus particulièrement mais non exclusivement le domaine technique des modules électroniques comprenant un organe destiné à être assemblé sur un support pour une application dans un véhicule automobile.

Un module électronique comprend en général un organe monté sur un support par l'intermédiaire d'un joint garantissant la liaison mécanique et électrique de l'organe avec le support.

De tels modules électroniques doivent être adaptés pour supporter des contraintes thermiques relativement fortes, la température locale à l'intérieur du véhicule automobile, notamment dans le compartiment moteur, pouvant atteindre des valeurs très supérieures à 150°C.

En particulier, le matériau formant le joint entre le support et l'organe doit avoir une température de fusion supérieure aux températures maximales auxquelles est soumis le module électronique afin d'éviter la désolidarisation du support et de l'organe lors de son utilisation.

Par exemple, un matériau comprenant essentiellement de l'argent est bien adapté car la température de fusion de l'argent est supérieure à 900°C.

Afin de réaliser un tel joint, il est connu de l'état de la technique, notamment de US 2005/0247760, de mettre en oeuvre un procédé d'assemblage d'un composant électronique sur un support par frittage d'une masse comprenant un mélange de poudre conductrice et de solvant.

Au cours de ce procédé d'assemblage, on retire le solvant de la masse par chauffage de la masse ce qui provoque l'évaporation du solvant.

Puis, on met en place la masse de poudre sur un film formant support provisoire et on met en place la pastille sur la masse. Ensuite, on chauffe et on applique une première force de compression sur la pastille et la masse. L'action de la chaleur et de la première force de compression provoque un pré-frittage de la masse de poudre et une liaison de la masse et de la pastille.

Après séparation de la masse liée à la pastille d'avec le support provisoire, on met en place la masse liée à la pastille sur un support définitif. Ensuite, on chauffe et on applique une deuxième force de compression sur la pastille contre la masse et le support définitif. L'action de la chaleur et de la deuxième force de compression provoque un frittage de la masse de poudre et une liaison de la masse et du support définitif.

Ainsi, au cours de ce procédé d'assemblage, la pastille est soumise à deux forces de compression d'intensité relativement élevée, ce qui risque d'endommager la pastille.

Par ailleurs, du fait que l'on applique deux fois une force de compression de la pastille contre la masse et qu'une seule fois une force de compression de la masse contre le support, l'adhérence de la masse à la pastille peut être plus forte que celle de la masse au support. Ce déséquilibre peut être à l'origine de contraintes à l'intérieur de la masse de poudre, fragilisant la liaison de la pastille et du support.

Le document US 2003/0102356 divulgue un procédé d'assemblage d'un composant électronique sur un support par frittage d'une masse comprenant un mélange de poudre conductrice et de solvant. Dans une première étape de compression le composant électronique et le support sont pressés l'un contre l'autre et la masse est partiellement pressée vers les bords du composant. Puis, on retire le solvant de la masse par chauffage ou par application d'une pression négative. Ensuite on chauffe l'assemblage pour provoquer le frittage de la masse de poudre. En option, on peut appliquer aussi une force de compression pendant l'étape de frittage.

L'invention a notamment pour but de proposer un procédé d'assemblage d'un module électronique comprenant un organe assemblé sur un support par frittage, permettant d'assurer une liaison solide entre l'organe et le support tout en préservant l'intégrité de l'organe au cours de l'assemblage et tout en étant relativement simple.

A cet effet, l'invention a pour objet un procédé d'assemblage d'un module électronique comprenant un organe destiné à être assemblé sur un support par frittage d'une masse de poudre conductrice destinée à former un joint entre l'organe et le support, ledit procédé comportant une étape de chauffage de la masse à une température prédéterminée et, avant l'étape de chauffage de la masse, les étapes suivantes :
- on met en place la masse de poudre conductrice sur le support puis l'organe sur la masse,
- on applique une force de compression de l'organe contre la masse et le support et on fait varier l'intensité de la force de compression de façon que,
   - on augmente l'intensité depuis une valeur initiale jusqu'à une première valeur prédéfinie d'agglomération de la masse, inférieure à un seuil de déformation plastique de la masse de poudre,
   - on maintient l'intensité à la première valeur prédéfinie pendant une durée prédéterminée d'agglomération de la masse de poudre de manière à ce que les particules de poudre de la masse soient mises en contact entre elles sous l'effet de la force de compression pendant toute la durée prédéterminée d'agglomération,
   - on augmente l'intensité de la première valeur jusqu'à une deuxième valeur prédéfinie inférieure à un seuil critique d'endommagement de l'organe mais supérieure à un seuil minimal de frittage de la masse pour la température prédéterminée, la deuxième valeur prédéfinie étant supérieure à la première valeur prédéfinie.

Lorsque l'intensité de la force de compression atteint la première valeur prédéfinie, la masse de poudre est mise en forme par agglomération des particules de poudre entre elles. Ainsi, les particules de poudre de la masse sont mises en contact entre elles sous l'effet de la force de compression pendant toute la durée prédéterminée d'agglomération. La première valeur prédéfinie de l'intensité de la force de compression est choisie inférieure à un seuil de déformation plastique de la masse ce qui permet d'éviter un effondrement brutal de la masse sur le support sous l'effet de la force de compression alors que les particules sont encore trop dispersées.

En particulier, dans le cas d'une masse comprenant un mélange de poudre et de solvant, la première valeur prédéfinie est telle que la compression de l'organe contre le masse et le support permet l'expulsion du solvant sur les bords de l'organe sans nécessiter un chauffage préalable de la masse.

L'augmentation de l'intensité de la force de compression de la première valeur à la deuxième valeur permet d'optimiser les surfaces de contact d'une part de la masse et de l'organe et d'autre part de la masse et du support par aplanissement de ces surfaces de contact, ceci assurant un transfert de chaleur optimal entre les éléments du module au cours du chauffage de la masse.

Par ailleurs, la deuxième valeur est choisie de telle manière que pour la température prédéterminée de chauffage de la masse, la compression de la masse est telle que la coalescence des particules de la poudre formant la masse, c'est-à-dire l'opération de frittage, est amorcée.

En outre, l'augmentation progressive de la force de compression ainsi que les valeurs des intensités des forces de compression choisies inférieures à la valeur critique d'endommagement de l'organe permettent de préserver l'intégrité de ce dernier.

Un procédé d'assemblage selon l'invention peut encore comporter les caractéristiques selon lesquelles :
- on maintient la valeur de l'intensité de la force de compression à la deuxième valeur prédéfinie au moins pendant une durée prédéterminée de chauffage de la masse ;
- on dirige un faisceau laser sur une première face du support opposée à une seconde face du support portant la masse, au droit de cette masse, pendant une période d'irradiation du support par le faisceau correspondant sensiblement à la durée prédéterminée de chauffage ;
- l'organe est une pastille semi-conductrice ;
- la masse de poudre conductrice comprend essentiellement de l'argent ;
- pour mettre en place la masse de poudre sur le support, on pulvérise de la poudre sur le support ;
- la température prédéterminée est inférieure à la température de fusion de la masse de poudre ;
- lors de la mise en place l'organe sur la masse, on déplace l'organe vers la masse jusqu'à détection d'une position de contact de l'organe avec la masse et lors de la détection de la position de contact, on règle la valeur initiale de l'intensité de la force de compression à une valeur sensiblement nulle ;
- la masse de poudre comprend un mélange de poudre conductrice et de solvant organique.

L'invention sera mieux comprise à la lecture de la description qui va suivre, donnée uniquement à titre d'exemple et faite en se référant aux dessins dans lesquels :
- la figure 1 est un schéma d'une installation d'assemblage d'un organe sur un support comprenant un dispositif d'agencement pour la mise en oeuvre d'un procédé d'assemblage selon l'invention ;
- les figures 2 à 6 sont des vues de face du dispositif d'agencement de la figure 1, illustrant différentes étapes du procédé d'assemblage selon l'invention.

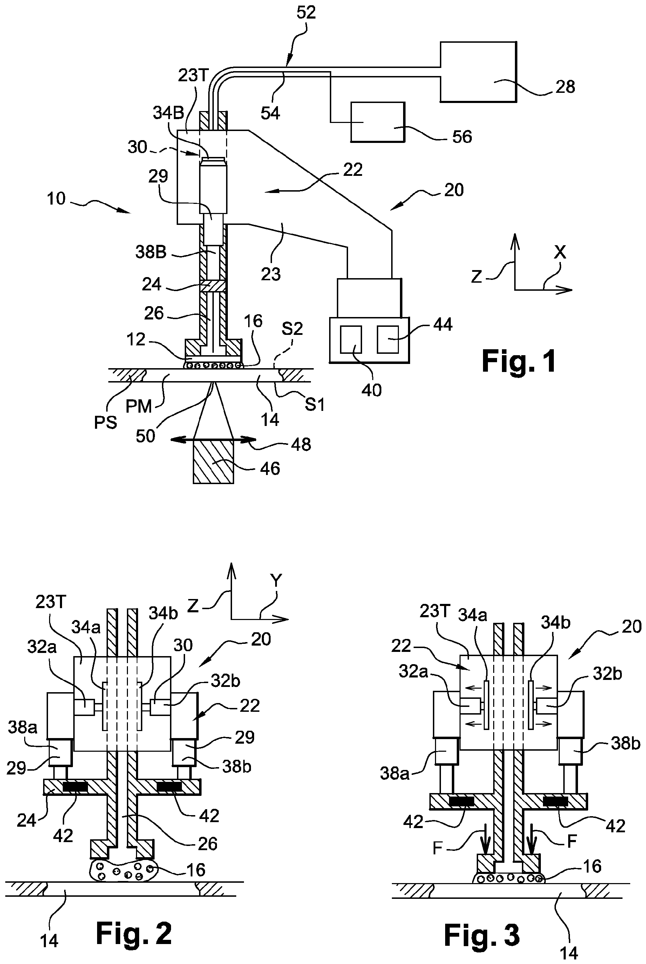

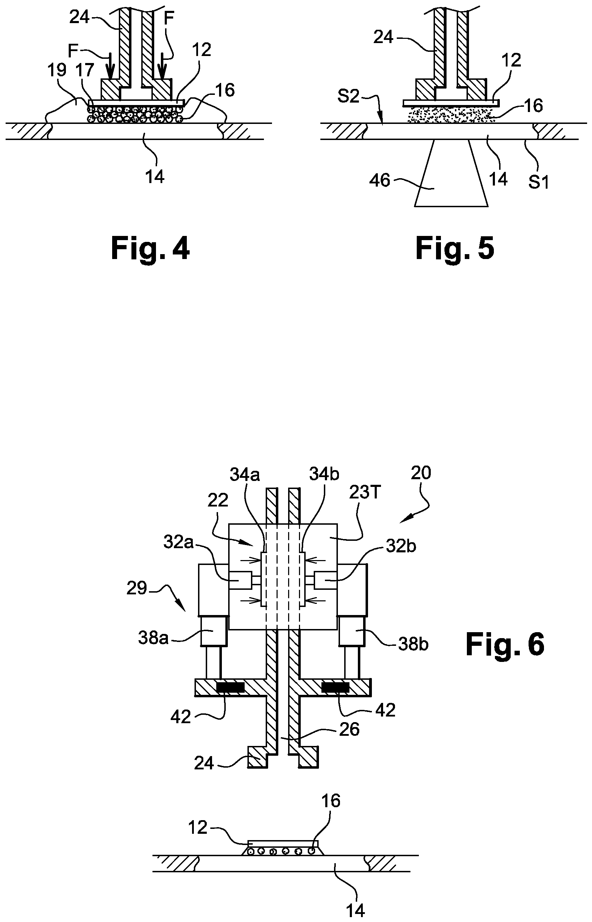

On a représenté sur la figure 1 une installation désignée par la référence générale 10. L'installation 10 permet d'assembler un organe 12 sur un support 14 par frittage d'une masse 16 formant joint. Dans l'exemple décrit, l'organe 12 est une pastille semi-conductrice, de type classique. La masse 16 se présente par exemple sous forme d'une poudre conductrice. De préférence, la masse de poudre conductrice comprend essentiellement de l'argent. Dans l'exemple illustré sur la figure 4, la masse 16 comprend un mélange d'une poudre conductrice 17 et d'un solvant organique 19.

Le support 14 comporte dans l'exemple décrit une partie métallique PM, notamment en cuivre, bordée partiellement par une partie PS en matériau synthétique formant une partie d'un boîtier de protection de la pastille semi-conductrice 12 portée par le support 14.

Le support 14 comporte des première S1 et seconde S2 faces opposées. La masse 16 est destinée à être portée par la seconde face S2 de la partie métallique PM du support. De préférence, la seconde face S2 est recouverte d'une fine couche de nickel.

Afin d'agencer la pastille 12 et la masse 16 sur le support 14, l'installation d'assemblage 10 comprend des moyens 20 de déplacement de la pastille 12 ou de la masse 16. Ces moyens de déplacement 20 comprennent des moyens articulés 22 permettant le déplacement de la pastille 12 ou de la masse 16 dans un plan horizontal sensiblement parallèle à des axes X et Y et dans une direction verticale sensiblement parallèle à un axe Z.

De préférence, les moyens articulés 22 comprennent un bras 23 muni d'une tête 23T portant des moyens 24 de préhension de la pastille 12 ou de la masse 16.

Les moyens de préhension 24 sont par exemple du type à aspiration. Ainsi, les moyens de préhension 24 comprennent un conduit d'aspiration 26 relié à des moyens d'aspiration 28 comportant par exemple une pompe à vide.

Les moyens de préhension 24 sont reliés à la tête 23T par l'intermédiaire de moyens 29 destinés à comprimer un premier élément, formé notamment par la pastille 12 ou la masse 16, sur un second élément, formé notamment par le support 14. Les moyens de compression 29 autorisent un déplacement relatif des moyens de préhension 24 et de la tête 23T sensiblement parallèlement à l'axe Z.

Toutefois, les moyens de préhension 24 peuvent être solidarisés avec la tête 23T à l'aide de moyens 30 de liaison libérables susceptibles d'adopter un état actif (voir figure 2) dans lequel les moyens 24 sont reliés à la tête 23T solidairement avec celle-ci et un état de repos (voir figure 3) dans lequel les moyens 24 sont libres par rapport à la tête 23T.

Les moyens de liaison libérables 30 comprennent de préférence des moyens de serrage comportant par exemple des premier 32a et deuxième 32b actionneurs linéaires à action horizontale (dans cet exemple parallèlement à l'axe Y), portés par la tête 23T. Ces premier 32a et deuxième 32b actionneurs portent respectivement des première 34a et deuxième 34b mâchoires de serrage (figures 2 à 6). Par exemple, les actionneurs 32a, 32b sont du type à vérin linéaire pneumatique à tige. Chaque mâchoire 34a, 34b est portée par une tige de vérin 32a, 32b correspondante.

Dans l'exemple décrit, dans l'état actif des moyens de liaison libérables 30, les mâchoires 34a, 34b enserrent les moyens de préhension 24 et, dans l'état de repos des moyens de liaison libérables 30, les mâchoires de serrage 34a, 34b sont écartées des moyens de préhension 24.

Les moyens de compression 29 comprennent par exemple des premier 38a et deuxième 38b actionneurs linéaires à action verticale (dans l'exemple parallèlement à l'axe Z), reliant la tête 23T aux moyens de préhension 24. Les actionneurs 38a, 38b sont destinés à appliquer une force verticale de compression du premier élément contre le deuxième élément en exerçant une poussée verticale sur les moyens de préhension 24.

Par exemple, les actionneurs 38a, 38b sont comme les actionneurs 32a, 32b du type à vérin linéaire pneumatique à tige.

L'intensité de la force de compression est réglée à l'aide de moyens de réglage 40 classiques représentés sur la figure 1.

L'installation 10 comprend encore des moyens 42 de détection d'une position de contact du premier élément sur le deuxième élément. Les moyens de détection 42 comprennent de préférence un capteur de pression intégré dans les moyens de préhension 24.

En variante, les moyens de détection 42 comprennent un détecteur à contact de type capacitif.

L'installation 10 comprend encore des moyens (non représentés) formant contrepoids à l'égard des moyens de déplacement 20, plus particulièrement à l'égard des moyens de préhension 24.

L'installation 10 comprend par ailleurs des moyens 44 de pilotage des moyens de compression 29. Ces moyens 44 permettent également de piloter les moyens formant contrepoids en fonction de la détection de la position de contact par les moyens 42.

Afin de chauffer la masse 16 pour provoquer le frittage de cette masse 16, l'installation 10 comprend également une source de chaleur, telle que par exemple une source laser émettant un faisceau 46.

L'installation 10 comprend encore des moyens 48 de focalisation du faisceau laser 46 en un point 50 au droit de la masse formant brasure 16.

Eventuellement, afin de contrôler la température de la masse 16 et de la pastille 12 au cours du chauffage, les moyens de déplacement 20 portent des moyens 52 de mesure de la température du type à infrarouge (voir figure 1).

Par exemple, les moyens de mesure 52 comportent une fibre optique 54 s'étendant dans le conduit d'aspiration 26 des moyens de préhension 24. Eventuellement, les moyens de mesure 52 comprennent également un pyromètre infrarouge 56 relié à la fibre optique 54.

On décrira ci-dessous, en référence aux figures 2 à 6, les principales étapes d'un procédé d'assemblage selon l'invention.

Tout d'abord, on agence l'organe 12 et la masse 16 sur le support 14 de la façon suivante.

On utilise à cet effet les moyens de déplacement 20 dans lesquels les moyens de liaison libérables 30 sont initialement actifs. Dans cet état, les mâchoires de serrage 34a, 34b enserrent les moyens de préhension 24 de sorte que ces moyens de préhension 24 sont solidaires de la tête 23T des moyens articulés 22. Aucune force de compression n'est appliquée sur la masse 16 du fait que les moyens 30 sont actifs.

Au cours d'une première étape, on met en place la masse 16 sur le support 14. Ainsi, au cours de cette première étape, tout d'abord on active les moyens d'aspiration 52 afin que la masse 16 soit saisie par les moyens de préhension 24. Puis la masse 16 est déplacée vers le support 14 par les moyens 20. Le déplacement des moyens de préhension 24 est relativement précis car directement lié à celui des moyens articulés 22.

Dès la détection de la position de contact de la masse 16 avec la surface S2 du support 14, on désactive les moyens d'aspiration 52 de sorte que les moyens de préhension 24 libèrent la masse 16 (figure 2). La masse 16 a une forme générale initiale relativement irrégulière. Par exemple, la masse 16 a une épaisseur d'environ 100 µm.

Dans une variante non illustrée, pour mettre en place la masse sur le support, on pulvérise de la poudre sur le support.

Au cours d'une deuxième étape, on met en place la pastille semi-conductrice 12 sur la masse 16. Les moyens de déplacement 20 saisissent la pastille 12 par aspiration et déplacent cette pastille 12 vers la masse 16.

Dès la détection de la position de contact de la pastille 12 avec la masse 16, les moyens de déplacement 20 s'immobilisent.

Les moyens de liaison 30 passent alors à l'état de repos dans lequel les mâchoires sont séparées des moyens de préhension 24.

Au cours d'une troisième étape, les moyens 44 pilotent les moyens de compression 29 de la façon suivante. Afin notamment de réduire les irrégularités, d'une part, de la surface de contact entre la pastille 12 et la masse 16 et, d'autre part, de la surface de contact entre la masse 16 et le support 14, et afin de mettre en contact entre eux les grains de la poudre 17, on applique sur la pastille 12, à l'aide des moyens 29, une force de compression F sollicitant la pastille 12 contre la masse 16 et le support 14. On fait varier l'intensité de la force F.

Dans une première phase de variation, on augmente l'intensité de la force F jusqu'à une première valeur prédéfinie d'agglomération de la masse 16. Cette première valeur est choisie inférieure à un seuil de déformation plastique de la masse de poudre 16. Par exemple, la première valeur prédéfinie est d'environ 10 grammes force.

De préférence, afin de contrôler précisément l'intensité de la force de compression F, dès la détection de la position de contact de la pastille 12 et de la masse 16, les moyens 44 pilotent également l'activation des moyens formant contrepoids des moyens de préhension 24. L'activation des moyens formant contrepoids et le réglage de la valeur de l'intensité de la force grâce aux moyens de réglage 40 permettent d'ajuster la valeur initiale de l'intensité de la force à une valeur sensiblement nulle.

Ainsi, lors de la détection de la position de contact de la pastille 12 avec la masse 16, on règle la valeur initiale de l'intensité de la force de compression à une valeur sensiblement nulle.

On augmente alors l'intensité de la force F depuis la valeur initiale sensiblement nulle, réglée lors de la détection de la position de contact, jusqu'à la première valeur prédéfinie d'agglomération de la masse 16.

De préférence, on augmente l'intensité de la force de compression par pas d'incrémentation de la valeur d'intensité jusqu'à la première valeur prédéfinie.

Dans une deuxième phase de variation, on maintient l'intensité de la force F à la première valeur prédéfinie pendant une durée prédéterminée d'agglomération de la masse de poudre 16. La durée prédéterminée d'agglomération est par exemple de 500 ms.

A cet effet, les moyens de préhension 24 descendent progressivement sous l'action de la sortie des tiges de vérin 38a, 38b de manière à maintenir l'intensité de la force de compression constante et égale à la première valeur prédéfinie et ce durant toute la durée prédéterminée d'agglomération des grains de la poudre 17.

Comme on peut le voir sur la figure 4, l'application de la force de compression F sollicitant la pastille 12 contre la masse 16 et le support 14 et ayant une intensité égale à la première valeur prédéfinie, provoque, d'une part, le fluage du solvant 19 sur les côtés de la pastille 12 et, d'autre part, une agglomération des grains de poudre 17 entre eux.

Dans une troisième phase de variation, on augmente l'intensité de la force F de la première valeur jusqu'à une deuxième valeur prédéfinie inférieure à un seuil critique d'endommagement de l'organe, mais supérieure à un seuil minimal de frittage de la masse 16 à la température prédéterminée. La deuxième valeur prédéfinie est supérieure à la première valeur prédéfinie.

Ainsi, on augmente l'intensité de la force F jusqu'à une deuxième valeur prédéfinie supérieure à la première valeur prédéfinie. Par exemple, la deuxième valeur prédéfinie est de 100 grammes force.

Après agencement de l'organe 12 et de la masse 16 sur le support 14 comme décrit, ci-dessus, on chauffe la masse 16 à une température prédéterminée pendant une durée prédéterminée. A cet effet, on dirige le faisceau laser 46 sur la première face S1 du support 14 (voir figure 5). Plus précisément, on dirige le faisceau laser 46 au droit de la masse 16 pendant une période d'irradiation du support 14 par le faisceau 46. Cette période d'irradiation correspond sensiblement à la durée prédéterminée de chauffage de la masse.

Au cours de cette période d'irradiation, les moyens de compression 29 sont pilotés de façon à maintenir la valeur de l'intensité de la force F à la deuxième valeur prédéfinie pendant la durée prédéterminée de chauffage de la masse. A cet effet, les moyens de préhension 24 descendent progressivement sous l'action de la sortie des tiges de vérin 38a, 38b, de manière à maintenir l'intensité de la force de compression constante et égale à la deuxième valeur prédéfinie et ce durant toute la durée prédéterminée de chauffage de la masse.

La chaleur générée au point 50 d'irradiation du support 14 par le faisceau laser 46 se propage à l'intérieur du support 14 jusqu'à atteindre la masse 16 et la pastille 12. La masse 16 est alors chauffée à une température prédéterminée.

Du fait que les irrégularités de surface ont été atténuées lors de la compression de la pastille 12 contre la masse 16 et le support 14, le transfert de chaleur est relativement bon entre le support 14 et la masse 16, ainsi qu'entre la masse 16 et la pastille 12.

Par ailleurs, la température prédéterminée et l'intensité de la force de compression sont choisies de manière à provoquer le frittage de la masse 16 et ainsi l'adhérence, d'une part, de la masse 16 et de la pastille 12 et, d'autre part, de la masse 16 et du support 14.

La température prédéterminée reste toujours inférieure à la température de fusion des grains de poudre d'argent formant la masse 16. La température de chauffage a une valeur comprise par exemple entre une valeur minimale de 200°C et une valeur maximale de 400°C, la valeur maximale correspondant à un seuil critique de résistance à la température de la pastille.

La deuxième valeur prédéfinie, à cette température prédéterminée, est supérieure au seuil de déformation plastique de la masse de poudre 16 de sorte que le frittage de la masse de poudre est amorcé.

Au cours de l'irradiation du support 14 par le faisceau laser 46 et du refroidissement de la masse 16, il est possible de contrôler la température notamment de la pastille 12 grâce aux moyens de mesure 52. En effet, la fibre optique 54 collecte le flux infrarouge émis par la pastille 12 et le transmet vers le pyromètre 56. Le pyromètre 56 convertit alors le flux lumineux collecté en une valeur de température.

Après refroidissement de la masse 16, les moyens d'aspiration 28 sont désactivés et les moyens de préhension 24 libèrent la pastille 12, comme illustré sur la figure 6. Les moyens 44 pilotent la désactivation des moyens de compression 29 et les moyens de liaison libérables 30 passent de l'état actif à l'état de repos de sorte que les moyens de préhension 24 sont de nouveau reliés à la tête 23T solidairement avec celle-ci et les moyens 20 déplacent les moyens de préhension 24, par exemple pour l'agencement et l'assemblage d'un nouvel élément sur le support 14.

Grâce au procédé d'assemblage, l'intensité de la force de compression appliquée sur la pastille, la masse et le support est homogène durant l'assemblage des éléments. Par ailleurs, du fait que l'on applique tout d'abord une force de compression d'intensité relativement faible égale à la première valeur prédéfinie inférieure au seuil de déformation plastique et que l'on maintient cette valeur d'intensité pendant une durée prédéterminée d'agglomération des grains de poudre, les grains de poudre 17 forment une masse cohérente à l'issue de la durée prédéterminée d'agglomération. Les valeurs de la température prédéterminée et de l'intensité de la force de compression pour réaliser le frittage de la masse peuvent être alors optimisées. Ainsi, l'application de la force de compression en deux temps permet de former un joint de qualité homogène entre le support et la pastille.

## Revendications

1. Procédé d'assemblage d'un module électronique comprenant un organe assemblé (12) sur un support (14) par frittage d'une masse (16) de poudre conductrice destinée à former un joint entre l'organe (12) et le support (14), ledit procédé comportant une étape de chauffage de la masse (16) à une température prédéterminée et, avant l'étape de chauffage de la masse (16), les étapes suivantes :
- on met en place la masse de poudre conductrice (16) sur le support (14) puis l'organe (12) sur la masse (16),
- on applique une force (F) de compression de l'organe (12) contre la masse (16) et le support (14) et on fait varier l'intensité de la force de compression (F) de façon que,
- on augmente l'intensité depuis une valeur initiale jusqu'à une première valeur prédéfinie d'agglomération de la masse (16), inférieure à un seuil de déformation plastique de la masse de poudre (16),
- on maintient l'intensité à la première valeur prédéfinie pendant une durée prédéterminée d'agglomération de la masse de poudre (16) de manière à ce que les particules de poudre de la masse (16) soient mises en contact entre elles sous l'effet de la force de compression pendant toute la durée prédéterminée d'agglomération,
- on augmente l'intensité de la première valeur jusqu'à une deuxième valeur prédéfinie inférieure à un seuil critique d'endommagement de l'organe (12) mais supérieure à un seuil minimal de frittage de la masse (16) pour la température prédéterminée, la deuxième valeur prédéfinie étant supérieure à la première valeur prédéfinie.

2. Procédé d'assemblage selon la revendication 1, dans lequel on maintient la valeur de l'intensité de la force de compression (F) à la deuxième valeur prédéfinie au moins pendant une durée prédéterminée de chauffage de la masse (16).

3. Procédé d'assemblage selon la revendication 2, dans lequel on dirige un faisceau laser (46) sur une première face (S1) du support (14) opposée à une seconde face (S2) du support (14) portant la masse (16), au droit de cette masse (16), pendant une période d'irradiation du support (14) par le faisceau (46) correspondant sensiblement à la durée prédéterminée de chauffage.

4. Procédé d'assemblage selon l'une quelconque des revendications 1 à 3, dans lequel l'organe (12) est une pastille semi-conductrice.

5. Procédé d'assemblage selon l'une quelconque des revendications 1 à 4, dans lequel la masse de poudre conductrice (16) comprend essentiellement de l'argent.

6. Procédé d'assemblage selon l'une quelconque des revendications 1 à 5, dans lequel, pour mettre en place la masse de poudre (16) sur le support (14), on pulvérise de la poudre sur le support (14).

7. Procédé d'assemblage selon l'une quelconque des revendications 1 à 6, dans lequel la température prédéterminée est inférieure à la température de fusion de la masse de poudre (16).

8. Procédé d'assemblage selon l'une quelconque des revendications 1 à 7, dans lequel, lors de la mise en place l'organe (12) sur la masse (16), on déplace l'organe (12) vers la masse (16) jusqu'à détection d'une position de contact de l'organe (12) avec la masse (16) et lors de la détection de la position de contact, on règle la valeur initiale de l'intensité de la force de compression (F) à une valeur sensiblement nulle.

9. Procédé d'assemblage selon l'une quelconque des revendications 1 à 8, dans lequel la masse de poudre (16) comprend un mélange de poudre conductrice (17) et de solvant organique (19).

## Patentansprüche

1. Verfahren zur Montage eines Elektronikmoduls, umfassend ein Element (12), das auf einen Träger (14) durch Sintern einer Masse (16) von leitfähigem Pulver, die dazu bestimmt ist, eine Dichtung zwischen dem Element (12) und dem Träger (14) zu bilden, montiert ist, wobei das Verfahren einen Schritt der Erhitzung der Masse (16) auf eine vorbestimmte Temperatur und vor dem Erhitzungsschritt der Masse (16) die folgenden Schritte umfasst:
- Anordnen der Masse von leitfähigem Pulver (16) auf dem Träger (14), dann des Elements (12) auf der Masse (16),
- Anlegen einer Kompressionskraft (F) des Elements (12) gegen die Masse (16) und den Träger (14) und Variieren der Stärke der Kompressionskraft (F), so dass:
- die Stärke von einem Anfangswert bis zu einem ersten vordefinierten Agglomerationswert der Masse (16) unter einer plastischen Verformungsgrenze der Pulvermasse (16) erhöht wird,
- die Stärke auf dem vordefinierten Wert während einer vorbestimmten Agglomerationsdauer der Pulvermasse (16) gehalten wird, so dass die Pulverpartikel der Masse (16) untereinander unter der Wirkung der Kompressionskraft während der gesamten vorbestimmten Agglomerationsdauer in Kontakt gebracht werden,
- die Stärke vom ersten Wert bis zu einem zweiten vordefinierten Wert unter einer kritischen Grenze der Beschädigung des Elements (12) aber über einer Mindestsintergrenze der Masse (16) für die vorbestimmte Temperatur erhöht wird, wobei der zweite vordefinierte Wert größer als der erste vordefinierte Wert ist.

2. Montageverfahren nach Anspruch 1, bei dem der Wert der Stärke der Kompressionskraft (F) auf dem zweiten vorbestimmten Wert zumindest während einer vorbestimmten Erhitzungsdauer der Masse (16) gehalten wird.

3. Montageverfahren nach Anspruch 2, bei dem ein Laserstrahl (46) auf eine erste Seite (S1) des Trägers (14), die einer zweiten Seite (S2) des Trägers (14), die die Masse (16) trägt, gegenüberliegt, im rechten Winkel zu dieser Masse (16) während einer Bestrahlungsperiode des Trägers (14) mit dem Strahl (46) im Wesentlichen entsprechend der vorbestimmten Erhitzungsdauer gerichtet wird.

4. Montageverfahren nach einem der Ansprüche 1 bis 3, bei dem das Element (12) ein Halbleiterwafer ist.

5. Montageverfahren nach einem der Ansprüche 1 bis 4, bei dem die Masse aus leitfähigem Pulver (16) im Wesentlichen Silber umfasst.

6. Montageverfahren nach einem der Ansprüche 1 bis 5, bei dem zum Anordnen der Pulvermasse (16) auf dem Träger (14) Pulver auf dem Träger (14) zerstäubt wird.

7. Montageverfahren nach einem der Ansprüche 1 bis 6, bei dem die vorbestimmte Temperatur niedriger als die Schmelztemperatur der Pulvermasse (16) ist.

8. Montageverfahren nach einem der Ansprüche 1 bis 7, bei dem beim Anordnen des Elements (12) auf der Masse (16) das Element (12) zu der Masse (16) verschoben wird, bis eine Kontaktposition des Elements (12) mit der Masse (16) erfasst wird, und bei der Erfassung der Kontaktposition der Anfangswert der Stärke der Kompressionskraft (F) auf einem Wert im Wesentlichen gleich Null eingestellt wird.

9. Montageverfahren nach einem der Ansprüche 1 bis 8, bei dem die Pulvermasse (16) ein Gemisch aus leitfähigem Pulver (17) und organischem Lösungsmittel (19) umfasst.

## Claims

1. Method for assembling an electronic module comprising a member (12) assembled on a support (14) by sintering of a mass (16) of conductive powder intended to form a joint between the member (12) and the support (14), said method comprising a step of heating of the mass (16) to a predetermined temperature and, before the step of heating of the mass (16), the following steps:
- the mass of conductive powder (16) is placed on the support (14) then the member (12) is placed on the mass (16),
- a force (F) of compression of the member (12) against the mass (16) and the support (14) is applied and the intensity of the compression force (F) is varied so that,
- the intensity is increased from an initial value to a first predefined value of agglomeration of the mass (16), below a threshold of plastic deformation of the mass of powder (16),
- the intensity is maintained at the first predetermined value for a predetermined time of agglomeration of the mass of powder (16) so that the particles of powder of the mass (16) are brought into contact with one another under the effect of the compression force throughout the predetermined agglomeration time,
- the intensity is increased from the first value to a second predefined value below a critical threshold of damage to the member (12) but above a minimum threshold of sintering of the mass (16) for the predetermined temperature, the second predefined value being greater than the first predefined value.

2. Assembly method according to Claim 1, in which the value of the intensity of the compression force (F) is maintained at the second predefined value at least for a predetermined time of heating of the mass (16).

3. Assembly method according to Claim 2, in which a laser beam (46) is directed onto a first face (S1) of the support (14) opposite a second face (S2) of the support (14) bearing the mass (16), in line with this mass (16), for a period of irradiation of the support (14) by the beam (46) corresponding substantially to the predetermined heating time.

4. Assembly method according to any one of Claims 1 to 3, in which the member (12) is a semiconductive pad.

5. Assembly method according to any one of Claims 1 to 4, in which the mass of conductive powder (16) comprises mainly silver.

6. Assembly method according to any one of Claims 1 to 5, in which, to place the mass of powder (16) on the support (14), the powder is sprayed onto the support (14).

7. Assembly method according to any one of Claims 1 to 6, in which the predetermined temperature is lower than the melting point of the mass of powder (16) .

8. Assembly method according to any one of Claims 1 to 7, in which, upon the placement of the member (12) on the mass (16), the member (12) is moved towards the mass (16) until a position of contact of the member (12) with the mass (16) is detected and, upon the detection of the position of contact, the initial value of the intensity of the compression force (F) is set at a substantially zero value.

9. Assembly method according to any one of Claims 1 to 8, in which the mass of powder (16) comprises a mixture of conductive powder (17) and of organic solvent (19).
